# EUROPÄISCHE PATENTSCHRIFT

(11) **EP 0 876 090 B1**
(45) Veröffentlichungstag und Bekanntmachung des Hinweises auf die Patenterteilung: **26.02.2003**
(21) Anmeldenummer: 98104444.9
(22) Anmeldetag: 12.03.1998
(51) Int. Cl.: H05K 9/00

(54) **Gehäuse mit Wandungen und wenigstens einer Öffnung darin**
Housing with walls and at least one opening in them
Coffret avec les parois et au moins une ouverture dans les parois

(30) Priorität: 14.03.1997 DE 29704674 U
(43) Veröffentlichungstag der Anmeldung: 04.11.1998
(73) Patentinhaber: M. Schall GmbH + Co. KG, 52399 Merzenich (DE)
(72) Erfinder: Schimmang, Horst, 50354 Hürth (DE)
(74) Vertreter: Paul, Dieter-Alfred, Dipl.-Ing.

(56) Entgegenhaltungen:
- EP-A- 0 269 126
- EP-A- 0 269 206
- EP-A- 0 656 742
- US-A- 4 929 802

## Beschreibung

Die Erfindung betrifft ein Gehäuse mit Wandungen und mit wenigstens einer Öffnung darin, die mittels einer Abdeckung, z. B. in Form einer Tür oder eines Fensters, verschließbar ist, wobei Abdeckung und Öffnung von Rahmenprofilen umgeben sind, welche Überlappungsbereiche bilden und die eine Abschirmeinrichtung zur Abschirmung zwischen den Rahmenprofilen gegen hochfrequente Wellen und Impulse aufweisen, wobei Abdeckung und Öffnung von Rahmenprofilen umgeben sind, welche Überlappungsbereiche bilden und die eine Abschirmeinrichtung zur Abschirmung zwischen den Rahmenprofilen gegen hochfrequente Wellen und Impulse aufweisen, wobei die Überlappungsbereiche an den einander zugewandten Seiten komplementäre Eingriffsprofilierungen aufweisen, die als Keilprofilierungen mit gegenüberliegenden Schrägflächen ausgebildet sind, welche formschlüssig ineinanderfassen.

Für nachrichtentechnische Sende- und Empfangsanlagen, Fernmeldeanlagen, Anlagen für militärische Zwecke, Datenverarbeitungsanlagen und auch für Steuer- und Meßgeräte werden Gehäuse benötigt, die gegen hochfrequente Einflüsse, z. B. elektromagnetische Interferenzen (EMI), elektromagnetische Pulse (EMP) oder nukleare elektromagnetische Pulse (NELP), abgeschirmt sind. Dies stellt bei nicht unterbrochenen Wandungen des Gehäuses kein Problem dar. Im Bereich von Türen und öffenbaren Fenstern sind die Wandungen des Gehäuses durch Spalte zwangsläufig unterbrochen. Hier müssen besondere Maßnahmen getroffen werden, damit das Gehäuse möglichst hochfrequenzdicht ist. Hierzu sind Abschirmeinrichtungen in vielfältigen Ausführungsformen bekannt.

In der EP-A-0 656 742 ist ein solches Gehäuse beschrieben. Sowohl die Öffnung als auch die als Abdeckung dienende Tür sind von Rahmenprofilen umgeben, wobei das türseitige Rahmenprofil einen Überlappungssteg aufweist. In diesem Überlappungssteg ist eine Umweltdichtung eingesetzt, die den Spalt zum Wandelement hin überbrückt und gegen Verschmutzung abdichtet. Dahinter ist in den Überlappungssteg ein V-förmiges Abschirmprofil aus Metall eingelassen, dessen einer V-Schenkel den Spalt zum Wandelement überbrückt und dort mit einer Kante kraftschlüssig anliegt. zusammen mit einem weiteren Abschirmprofil entsteht hierdurch eine Abdichtung gegen die oben erwähnten hochfrequenten Wellen und Impulse. Eine ähnliche Lösung läßt sich der WO 88/04129 entnehmen.

In der gattungsbildenden EP-A-0 269 206 ist ein Gehäuse mit einer Tür beschrieben, wobei Tür und Öffnung Überlappungsbereiche bilden, die an den einander zugewandten Seiten komplementäre Eingriffsprofilierungen aufweisen, die als Keilprofilierungen mit gegenüber liegenden Schrägflächen ausgebildet sind und formschlüssig ineinander fassen. Die Keilprofilierungen bilden komplementäre Keilrippen und Keilnuten. zur elektromagnetischen Abschirmung sind in die Nutgründe der Keilnuten Dichtprofile eingelegt, in die bei geschlossener Tür die Spitzen der Keilrippen einfassen.

Insbesondere große Gehäuse in Containerform werden durch Öffnungen in den Wandungen in ihrer Stabilität erheblich beeinträchtigt, zumal solche Container beim Transport wie auch bei der Aufstellung bzw. Stapelung hohen Kräften ausgesetzt sind. Der Erfindung liegt deshalb die Aufgabe zugrunde, ein Gehäuse der vorliegenden Art so zu gestalten, daß es trotz des Vorhandenseins von Öffnungen besonders stabil ist.

Diese Aufgabe wird erfindungsgemäß dadurch gelöst, daß gegenüberliegende Schrägflächen vorhanden sind, die unter Ausbildung von Kontaktflächen aneinander anliegen. Aufgrund der erfindungsgemäßen Ausbildung verhaken sich Wandung und Abdeckung in geschlossenem Zustand derart, daß die Öffnung über die Abdeckung stabilisiert wird. Abdekkung und Wandung bilden praktisch eine Einheit, und das Vorhandensein der Öffnung führt nicht zu einer wesentlichen Beeinträchtigung der gesamten Stabilität des Gehäuses. Vorzugsweise sollten die Eingriffsprofilierungen derart ausgebildet sein, daß sich zumindest drei aneinanderiiegende Kontaktflächenpaare ergeben.

Ein überraschender Effekt ist dabei, daß die Kontaktflächen gleichzeitig auch eine gute Abschirmung gegen hochfrequente Wellen und Impulse bilden, wobei die Kontaktflächen möglichst unterbrechungslos über den gesamten Umfang der Rahmenprofile gehen sollten. Die Hochfrequenzabdichtung kann noch verbessert werden, wenn die Kontaktflächen einen zinnbelag erhalten. Eine weitere Verbesserung ist dadurch möglich, daß die Eingriffsprofilierungen wenigstens eine Längsnut aufweisen, in die jeweils ein Abschirmelement eingesetzt ist. Dabei können die bzw. eine der Längsnuten in eine Kontaktfläche eingeformt sein.

Als Abschirmelemente für die Längsnut(en) kommen verschiedene Ausführungsformen in Frage. Eine mögliche Ausführungsform besteht darin, eine Schraubenfeder in die Längsnut einzulassen, welche in geschlossenem Zustand der Abdeckung an der jeweils gegenüberliegenden Kontaktfläche anliegt. Um eine möglichst großflächige Anlage zu erhalten, sollte die Schraubenfeder aus Flachdraht gewickelt sein. Zusätzlich kann ein Stützkern vorgesehen sein.

Die Anzahl der Längsnuten kann entsprechend den jeweiligen Gegebenheiten gewählt werden. Schon mit zwei Längsnuten und darin angeordneten Abschirmelementen kann eine gute Abschirmung gegen hochfrequente Wellen und Impulse erzielt werden.

Nach einem weiteren Merkmal der Erfindung ist vorgesehen, daß in wenigstens einem Profilgrund der Eingriffsprofilierung(en) eine Längsnut vorgesehen ist. Diese Längsnut(en) bietet Freiraum, um eventuelle Verschmutzungen in diesen verdrängen zu können. Dabei sollten nach Möglichkeit in jedem Profilgrund eine Längsnut eingeformt sein. Zusätzlich können auch diese Längsnut(en) für die Anordnung von Abschirmelementen genutzt werden, beispielsweise in Form einer Dichtschnur aus metallischem Mesh-Gewebe.

Nach einem weiteren Merkmal der Erfindung ist vorgesehen, daß im Überlappungsbereich eine Umweltdichtung angeordnet ist. Sie kann beispielsweise einen Kunststoffstrang aufweisen, der in einer Nut in dem einen Rahmenprofil sitzt und gegen die ein Rahmensteg des anderen Rahmenprofils gepreßt ist. Um auch insoweit die Hochfrequenzabschirmung zu unterstützen, sollte der Kunststoffstrang eine Metalleinlage aufweisen. Zur Erzielung einer besseren Elastizität sollte der Kunststoffstrang im Nutgrund über Rippen abgestützt sein.

Nach der Erfindung ist ferner vorgesehen, daß eines der Rahmenprofile als Hohlprofil ausgebildet ist, welches an der den Eingriffsprofilierungen abgewandten Seite mit einem Wandungsabschnitt einen zweiten Überlappungsbereich bildet, wobei Hohlprofil und Wandungsabschnitt in diesem Bereich über Befestigungsmittel unter Bildung von Kontaktflächen miteinander verbunden sind. Dabei sollten Hohlprofil und wandungsabschnitt zwei Eingriffsprofilierungen unter Ausbildung der Kontaktflächen bilden. Dies kann dadurch verwirklicht werden, daß die hohlprofilseitige Eingriffsprofilierung aus Nuten mit Kontaktflächen an den Nutausläufen gebildet sind, in die wandabschnittseitig eingeformte Eingriffsstege einfassen.

Nach einem weiteren Merkmal der Erfindung ist vorgesehen, daß die Rahmenprofile an der den Eingriffsprofilierungen abgewandten Seite einen weiteren Überlappungsbereich bilden und dort über wenigstens ein weiteres Abschirmelement aneinanderliegen. Hierdurch wird auch an der anderen Seite des Gehäuses eine elektromagnetische Abschirmung bewirkt, die die Abschirmung aufgrund der Eingriffsprofilierungen unterstützt.

Schließlich ist gemäß der Erfindung vorgesehen, daß die Abschirmelemente nicht nur als Schraubenfedern ausgebildet sind, sondern zumindest teilweise als Längsblattfedern.

In der Zeichnung ist die Erfindung anhand von Ausführungsbeispielen näher veranschaulicht. Es zeigen:
- Figur 1: einen Horizontalschnitt mit Rahmenprofilen, die zur Wandung eines Gehäuses gehören und
- Figur 2: einen Horizontalschnitt mit einer zweiten Version von Rahmenprofilen, die zur Wandung eines Gehäuses gehören.

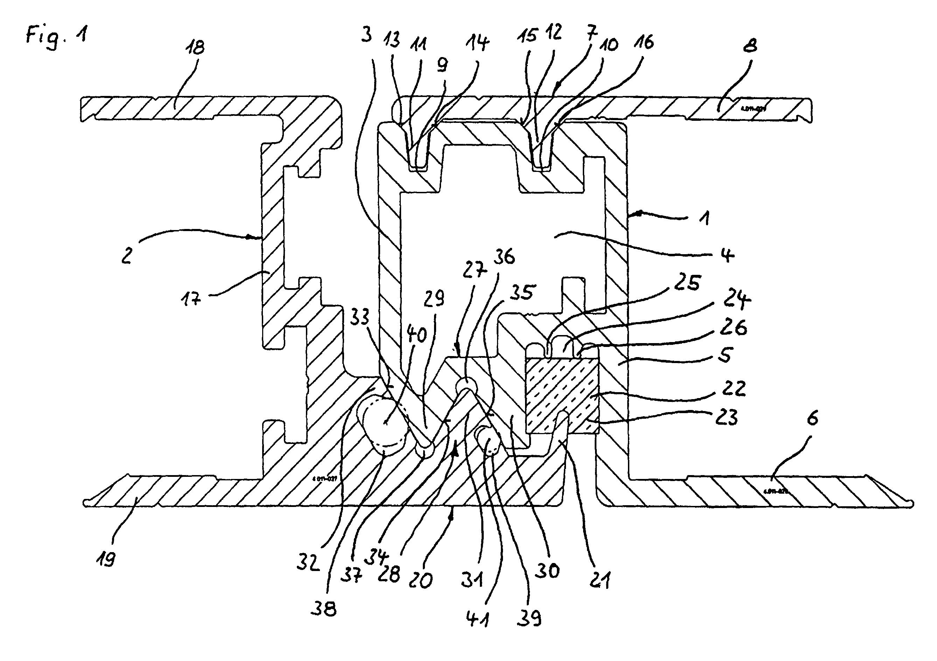

Der Ausschnitt gemäß Figur 1 ist reduziert auf ein wandseitiges Rahmenprofil 1 und ein türseitiges Rahmenprofil 2. Beide Rahmenprofile 1, 2 sind über ein übliches Türscharnier miteinander verbunden, das hier der Übersichtlichkeit halber weggelassen ist. Beide Rahmenprofile 1, 2 sind stranggepreßte Aluminiumprofile.

Das wandseitige Rahmenprofil 1 ist zweiteilig ausgebildet. Es hat einen Hohlprofilkörper 3, in dessen Innenraum 4 unten- und obenseitig Eckprofile eingesetzt werden können. Der Hohlprofilkörper 3 hat wandseitig eine Querwand 5, die bis zur Außenseite geht und dort rechtwinklig in einen Einfaßschenkel 6 ausläuft.

Die Innenseite des Hohlprofilkörpers 3 wird von einem Innenprofil 7 abgedeckt, das zur Wandung hin ebenfalls in einen Einfaßschenkel 8 ausläuft, der parallel zu dem anderen Einfaßschenkel 6 verläuft. Beide Einfaßschenkel 6, 8 liegen mit ihren Innenseiten an der Außenseite des hier nicht dargestellten Wandelements an, fassen dieses also im Bereich der Stirnseite ein und sind mit dem Wandelement fest verbunden.

Der Hohlprofilkörper 3 weist zwei Längsnuten 9, 10 auf, in die Längsstege 11, 12 einfassen, welche von dem Innenprofil 7 vorstehen. Die Längsnuten 9, 10 weisen im jeweiligen Nutauslaufbereich Abschrägungen auf, die mit komplementären Abschrägungen an den Längsstegen 11, 12 derart korrespondieren, daß insgesamt vier Kontaktflächenpaare 13, 14, 15, 16 gebildet werden. Die Kontaktflächenpaare 13, 14, 15, 16 liegen unter Vorspannung aneinander an, da das Innenprofil 7 an dem Hohlprofilkörper 3 über eine Vielzahl von Nieten miteinander verbunden ist.

Das türseitige Rahmenprofil 2 weist eine Querwand 17 mit innen- und außenseitiger Profilierung für den Einsatz von Schließelementen o. dgl. auf. Von den Außenseiten der Querwand 17 gehen parallele Einfaßschenkel 18, 19 aus, die dem Einfassen des Stirnseitenbereichs eines Türblatts dienen. Deren Innenseiten liegen unter Vorspannung an den Außenseiten des Türblatts an, wenn beide miteinander verbunden sind.

Außenseitig setzt sich das türseitige Rahmenprofil 2 in einem Überlappungssteg 20 fort, welcher mit dem Hohlprofilkörper 3 überlappt. Der Überlappungssteg 20 läuft in einer auf den Hohlprofilkörper 3 gerichteten Dichtleiste 21 aus. Diese Dichtleiste 21 faßt in einen gummielastischen Kunststoffstrang 22 ein, der eine Umweltdichtung bildet und zusätzlich Metalleinlagen 23 enthält, um eine ergänzende elektromagnetische Abschirmung zu erzielen. Der Kunststoffstrang 22 sitzt in einer vertikalen Längsnut 24, welche von der Querwand 5 und dem Hohlprofilkörper 3 gebildet wird. Rückseitig stützt sich der Kunststoffstrang 22 über zwei Rippen 25, 26 ab, die die Nachgiebigkeit des Kunststoffstrangs 22 fördern.

Sowohl der Hohlprofilkörper 3 als auch der Überlappungssteg 20 weisen an ihren einander gegenüberliegenden Seiten Eingriffsprofilierungen 27, 28 auf, die komplementär zueinander ausgebildet sind. Die Eingriffsprofilierung 27 besteht aus einer Keilrippe 29 und einem Vorsprung 30, wobei Keilrippe 29 und Vorsprung 30 eine V-förmige Nut einschließen. Dieser Nut gegenüber ist eine komplementäre Keilrippe 31 der Eingriffsprofilierung 28. Ferner hat die Eingriffsprofilierung 28 eine Schräge 32. Diese sowie die Keilrippe 31 schließen eine Nut ein, in die die Keilrippe 29 komplementär einfaßt. Dabei werden insgesamt drei Kontaktflächenpaare 33, 34, 35 gebildet, über die die Eingriffsprofilierungen 27, 28 aneinander anliegen. Die Kontaktflächenpaare 33, 34, 35 sind mit einem Zinnbelag versehen, um einen möglichst guten elektrischen Kontakt zu bilden.

Jeweils im Nutgrund der Nuten beider Eingriffsprofilierungen 27, 28 sind etwa halbkreisförmige Ausnehmungen 36, 37 eingeformt. Sie bilden in erster Linie Verdrängungsraum für eventuelle Verschmutzungen. Sie können jedoch auch zum Einsatz von Abschirmelementen, beispielsweise Mesh-Geweben aus Kupfer und Zinn benutzt werden, um die elektromagnetische Abschirmung noch weiter zu verbessern.

In der Schräge 32 sowie in der Keilrippe 31 sind Längsnuten 38, 39 eingeformt, in die Schraubenfedern 40, 41 als weitere elektromagnetische Abschirmelemente eingesetzt sind. Sie bestehen aus einer Kupfer-Beryllium-Zinn-Legierung und sind aus Flachdraht hergestellt, so daß sich eine weitgehend lükkenfreie flächige Anlage an der jeweils gegenüberliegenden Kontaktfläche ergibt. Insgesamt wird hierdurch eine hochwirksame elektromagnetische Abschirmung erreicht.

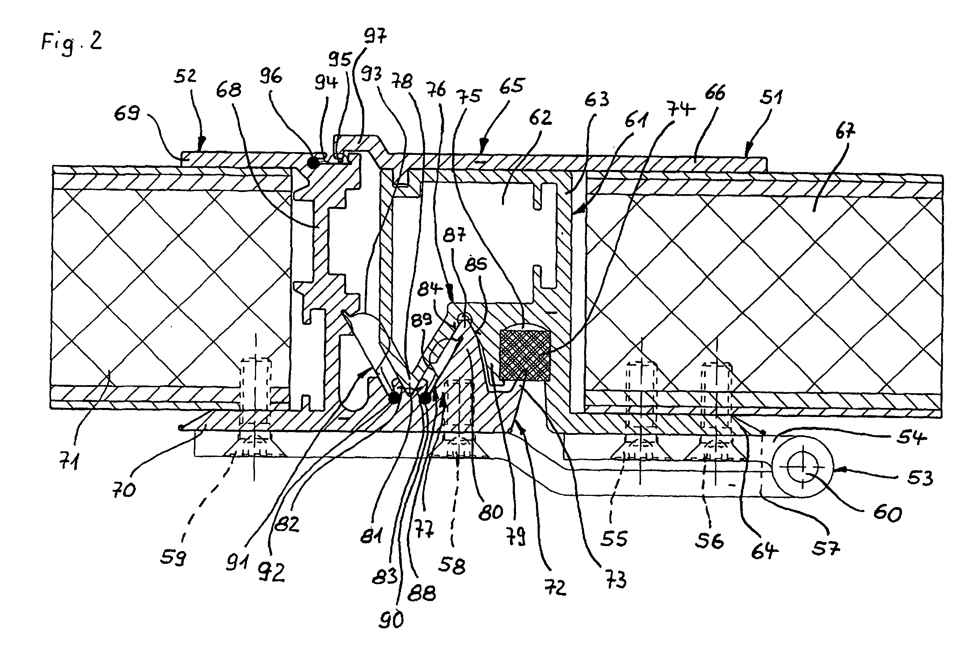

In Figur 2 ist ebenfalls ein wandseitiges Rahmenprofil 51 und ein türseitiges Rahmenprofil 52 dargestellt. Beide Rahmenprofile 51, 52 sind über ein übliches Türscharnier 53 verbunden, dessen erstes Scharnierblatt 54 mit dem wandseitigen Rahmenprofil 51 über Schrauben 55, 56 und dessen zweites Scharnierblatt 57 über Schrauben 58, 59 mit dem türseitigen Rahmenprofil 52 fest verbunden sind. Ein Scharniergelenk 60 verbindet beide Scharnierblätter 54, 57.

Das wandseitige Rahmenprofil 51 ist zweiteilig ausgebildet. Es hat einen Hohlprofilkörper 61, in dessen Innenraum 62 unten- und obenseitig Eckprofile eingesetzt werden können. Der Hohlprofilkörper 61 hat wandseitig eine Querwand 63, die bis zur Außenseite geht und dort rechtwinklig in einen Einfaßschenkel 64 übergeht.

Gehäuseinnenseitig wird der Hohlprofilkörper 61 von einem Innenprofil 65 abgedeckt, das ebenfalls in einen Einfaßschenkel 66 ausläuft, der sich parallel zu dem anderen Einfaßschenkel 64 erstreckt. Beide Einfaßschenkel 64, 66 sind über ihre Innenseiten an der Außenseite eines Wandelements 67 befestigt, das als übliche Sandwich-Platte ausgebildet ist.

Das türseitige Rahmenprofil 52 weist eine Querwand 68 auf. Von den Außenseiten der Querwand 68 gehen parallele Einfaßschenkel 69, 70 aus, die den Stirnseitenbereich eines Türblatts 71 einfassen. Auch das Türblatt 71 besteht aus einer üblichen Sandwich-Platte. Türblatt 71 und Einfaßschenkel 69, 70 sind fest miteinander verbunden.

An der Außenseite des Gehäuses setzt sich das türseitige Rahmenprofil 52 in einem Überlappungssteg 72 fort, welcher mit dem Hohlprofilkörper 61 überlappt. Der Überlappungssteg 72 läuft in einer auf den Hohlprofilkörper 61 gerichteten Dichtleiste 73 aus. Sie faßt in einen gummielastischen Kunststoffstrang 74 ein, der eine Umweltdichtung bildet. Er kann wie in dem Ausführungsbeispiel gemäß Figur 1 zusätzliche Metalleinlagen enthalten, um eine ergänzende elektromagnetische Abschirmung zu erzielen. Der Kunststoffstrang 74 sitzt in einer vertikalen Längsnut 75, welche von der Querwand 63 und dem Hohlprofilkörper 61 gebildet ist. Rückseitig ist die Längsnut 75 ausgewölbt, um die Nachgiebigkeit des Kunststoffstrangs 74 zu fördern.

Sowohl der Hohlprofilkörper 61 als auch der Überlappungssteg 72 weisen an ihren einander gegenüberliegenden Seiten Eingriffsprofilierungen 76, 77 auf, die komplementär zueinander ausgebildet sind. Die Eingriffsprofilierung 76 besteht aus einer Keilrippe 78 und einem Vorsprung 79, wobei Keilrippe 78 und Vorsprung 79 eine V-förmige Nut einschließen. Dieser Nut gegenüber befindet sich eine komplementäre Keilrippe 80 der Eingriffsprofilierung 77. Ferner hat die Eingriffsprofilierung 77 eine V-förmige Nut 81, in die die Keilrippe 78 komplementär einfaßt. Dabei werden im geschlossenen Zustand des Türblatts 71 vier Kontaktflächenpaare 82, 83, 84, 85 gebildet, über die die Eingriffsprofilierungen 76, 77 aneinander anliegen.

Im Nutgrund der Nut, in die die Keilrippe 78 einfaßt, ist eine etwas mehr als halbkreisförmige Ausnehmung 87 eingeformt. Sie bildet auch hier in erster Linie Verdrängungsraum für eventuelle Verschmutzungen. Sie ist jedoch auch für das Einsetzen eines Mesh-Abschirmgewebes aus Kupfer und Zinn vorgesehen, um die elektromagnetische Abschirmung noch weiter zu verbessern.

In die Schräge der Keilrippe 80, die der Keilrippe 78 gegenüberliegt, ist eine flache Nut eingeformt, in die eine Abschirmfeder 88 eingesetzt und dort formschlüssig gehalten ist. Die Abschirmfeder 88 besteht aus einer Kupfer-Beryllium-Zinn-Legierung und weist einen aus der Nut herausragenden Federschenkel 89 auf. Er ist in der Zeichnung in unbeaufschlagtem Zustand dargestellt. Tatsächlich wird er durch die Keilrippe 78 verformt und liegt deshalb an ihr auch mit Vorspannung an. Ein Sicherungsdraht 90 sorgt dafür, daß die Abschirmfeder 88 nicht aus der Nut herausfallen kann.

Auf der anderen Seite der Keilrippe 78 befindet sich eine gleichartige Abschirmfeder 91. Sie ist mit einer Längskante in der Querwand 68 und mit der anderen Kante in dem Überlappungssteg 72 gehalten und dort auch mit Hilfe eines Sicherungsdrahts 92 gesichert. Ihr Federschenkel 93 ist gleichfalls unbeaufschlagt gezeichnet. Tatsächlich wird er durch die Keilrippe 78 bei geschlossenem Türblatt 71 verformt, so daß er mit Vorspannung an der Keilrippe 78 anliegt. Beide Abschirmfedern 88, 91 bilden weitere elektromagnetische Abschirmelemente.

Eine weitere Abschirmfeder 94 ist in eine Nut 95 eingesetzt, welche in den innenseitigen Einfaßschenkel 70 eingeformt ist. Auch diese Abschirmfeder 94 ist durch einen Sicherungsdraht 96 gegen Herausfallen abgesichert. An der Abschirmfeder 94 liegt eine Fortsetzung 97 des Einfaßschenkels 66 an, so daß auch sie leicht zusammengedrückt wird. Hierdurch ergibt sich eine weitere Abschirmung.

## Patentansprüche

1. Gehäuse mit Wandungen (67) und wenigstens einer Öffnung darin, die mittels einer Abdeckung, z. B. in Form einer Tür (71) oder eines Fensters, verschließbar ist, wobei Abdeckung (71) und Öffnung von Rahmenprofilen (1, 2; 51, 52) umgeben sind, welche Überlappungsbereiche bilden und die eine Abschirmeinrichtung zur Abschirmung zwischen den Rahmenprofilen (1, 2; 51, 52) gegen hochfrequente Wellen und Impulse aufweisen, wobei die Überlappungsbereiche an den einander zugewandten Seiten komplementäre Eingriffsprofilierungen (27, 28; 76, 77) aufweisen, die als Keilprofilierungen (29, 31; 78, 80) mit gegenüberliegenden Schrägflächen ausgebildet sind, welche formschlüssig ineinanderfassen, wobei gegenüberliegende Schrägflächen vorhanden sind, **dadurch gekennzeichnet, daß** die Schrägflächen unter Ausbildung von Kontaktflächen (33, 34, 35; 82, 83, 84, 85) aneinander anliegen.

2. Gehäuse nach Anspruch 1, **dadurch gekennzeichnet, daß** die Eingriffsprofilierungen (27, 28; 76, 77) derart ausgebildet sind, daß sich zumindest drei aneinanderliegende Kontaktflächenpaare (33, 34, 35; 82, 83, 84, 85) ergeben.

3. Gehäuse nach Anspruch 1 oder 2, **dadurch gekennzeichnet, daß** die Kontaktflächen (33, 34, 35; 82, 83, 84, 85) einen Zinnbelag aufweisen.

4. Gehäuse nach einem der Ansprüche 1 bis 3, **dadurch gekennzeichnet, daß** wenigstens eine der Eingriffsprofilierungen (27, 28; 77) wenigstens eine Längsnut (38, 39) aufweisen, in die jeweils ein Abschinnelement (40, 41; 88, 91) eingesetzt ist.

5. Gehäuse nach Anspruch 4, **dadurch gekennzeichnet, daß** die bzw. wenigstens eine der Längsnuten (38, 39) in eine Kontaktfläche (33, 35; 84) eingeformt ist.

6. Gehäuse nach Anspruch 5, **dadurch gekennzeichnet, daß** in die Längsnut(en) jeweils eine Schraubenfeder (40, 41) als Abschirmelement eingesetzt ist, welche in geschlossenem zustand der Abdeckung an der jeweils gegenüberliegenden Kontaktfläche anliegt.

7. Gehäuse nach Anspruch 6, **dadurch gekennzeichnet, daß** die Schraubenfeder (40, 41) aus Flachdraht besteht.

8. Gehäuse nach Anspruch 6 oder 7, **dadurch gekennzeichnet, daß** die Schraubenfeder(n) (40, 41) einen Stützkern aufweist.

9. Gehäuse nach einem der Ansprüche 5 bis 8, **dadurch gekennzeichnet, daß** zwei Längsnuten (38, 39) vorgesehen sind.

10. Gehäuse nach einem der Ansprüche 1 bis 9, **dadurch gekennzeichnet, daß** in wenigstens einem Profilgrund der Eingriffsprofilierung(en) (27, 28) eine Längsnut (36, 37; 87) vorgesehen ist.

11. Gehäuse nach Anspruch 10, **dadurch gekennzeichnet, daß** Längsnuten (36, 37) in jedem Profilgrund eingeformt sind.

12. Gehäuse nach Anspruch 10 oder 11, **dadurch gekennzeichnet, daß** in die Längsnut(en) jeweils ein Abschirmelement eingesetzt ist.

13. Gehäuse nach Anspruch 12, **dadurch gekennzeichnet, daß** in die Längsnut(en) (36, 37) eine Dichtschnur, z. B. ein metallisches Mesh-Gewebe mit Stützkern, eingesetzt ist bzw. sind.

14. Gehäuse nach einem der Ansprüche 1 bis 13, **dadurch gekennzeichnet, daß** im Überlappungsbereich eine Umweltdichtung (21, 22; 74) angeordnet ist.

15. Gehäuse nach Anspruch 14, **dadurch gekennzeichnet, daß** die Umweltdichtung einen Kunststoffstrang (22; 74) aufweist, der in einer Nut (24; 75) in dem einen Rahmenprofil (1) sitzt und gegen die ein Rahmensteg (21; 72) des anderen Rahmenprofils (2; 52) gepreßt ist.

16. Gehäuse nach Anspruch 15, **dadurch gekennzeichnet, daß** der Kunststoffstrang (22; 74) eine Metalleinlage (23) aufweist.

17. Gehäuse nach Anspruch 15 oder 16, **dadurch gekennzeichnet, daß** der Kunststoffstrang (22) im Nutgrund über Rippen (25, 26) abgestützt ist.

18. Gehäuse nach einem der Ansprüche 1 bis 17, **dadurch gekennzeichnet, daß** eines der Rahmenprofile (1) als Hohlprofil (3) ausgebildet ist, welches an der den Eingriffsprofilierungen (27, 28) abgewandten Seite mit einem Wandungsabschnitt (7) einen weiteren Überlappungsbereich bildet, wobei Hohlprofil (3) und Wandungsabschnitt (7) in diesem Bereich über Befestigungsmittel unter Bildung von Kontaktflächen (13, 14, 15, 16) miteinander verbunden sind.

19. Gehäuse nach Anspruch 18, **dadurch gekennzeichnet, daß** Hohlprofil (3) und Wandungsabschnitt (7) zweite Eingriffsprofilierungen unter Ausbildung der Kontaktflächen (13, 14, 15, 16) bilden.

20. Gehäuse nach Anspruch 19, **dadurch gekennzeichnet, daß** die hohlprofilseitige Eingriffsprofilierung aus Nuten (9, 10) mit Kontaktflächen an den Nutausläufen ausgebildet sind, in die wandabschnittseitig eingeformte Eingriffsstege (11, 12) einfassen.

21. Gehäuse nach einem der Ansprüche 1 bis 20, **dadurch gekennzeichnet, daß** die Rahmenprofile (51, 52) an der den Eingriffsprofilierungen (76, 77) abgewandten Seite einen weiteren Überlappungsbereich bilden und dort über wenigstens ein weiteres Abschirmelement (94) aneinanderliegen.

22. Gehäuse nach einem der Ansprüche 1 bis 21, **dadurch gekennzeichnet, daß** die Abschirmelemente teilweise als Längsblattfedern (88, 91, 94) ausgebildet sind.

## Claims

1. Housing with walls (67) which have at least one opening in them that can be closed by means of a cover, for example in the form of a door (71) or a window, cover (71) and opening being enclosed by frame profiles (1, 2; 51, 52), which form areas of overlap and which have screening means between said frame profiles (1, 2; 51, 52) for shielding against high-frequency waves and pulses, the overlapping areas having, on the sides facing one another, complementary interlocking profiles (27, 28; 76, 77) taking the form of wedge profiles (29, 31; 78, 80) having opposed inclined surfaces, which interlock, inclined surfaces being provided opposite, **characterized in that** the inclined surfaces butt against one another to form contact surfaces (33, 34, 35; 82, 83; 84. 85).

2. Housing according to Claim 1, **characterized in that** the interlocking profiles (27, 28; 76, 77) are formed in such a way that there are at least three pairs of adjoining contact surfaces (33, 34, 35; 82, 83, 84, 85).

3. Housing according to Claim 1 or 2, **characterized in that** the contact surfaces (33, 34, 35; 82, 83, 84, 85) have a tin coating.

4. Housing according to one of Claims 1 to 3, **characterized in that** at least one of the interlocking profiles (27, 28; 77) has at least one longitudinal groove (38, 39), into which a screening element (40, 41; 88, 91) is inserted.

5. Housing according to Claim 4, **characterized in that** the longitudinal grooves or at least one of the longitudinal grooves (38, 39) is formed in a contact surface (33, 35; 84).

6. Housing according to Claim 5, **characterized in that** in each case a helical spring (40, 41) is inserted into the longitudinal groove or grooves as a screening element which, in the closed state of the cover, butts against the respective opposite contact surface.

7. Housing according to Claim 6, **characterized in that** the helical spring (40, 41) is made of flat wire.

8. Housing according to Claim 6 or 7, **characterized in that** the helical spring or springs (40, 41) have a supporting core.

9. Housing according to one of Claims 5 to 8, **characterized in that** two longitudinal grooves (38, 39) are provided.

10. Housing according to one of Claims 1 to 9, **characterized in that** at the base of at least one of the interlocking profiles (27, 28) a longitudinal groove (36, 37; 87) is provided.

11. Housing according to Claim 10, **characterized in that** longitudinal grooves (36, 37) are formed at the base of each profile.

12. Housing according to Claim 10 or 11, **characterized in that** a screening element is inserted into each longitudinal groove.

13. Housing according to Claim 12, **characterized in that** a sealing cord, e.g. a metallic mesh fabric with supporting core, is inserted into the longitudinal groove or grooves (36, 37).

14. Housing according to one of Claims 1 to 13, **characterized in that** an environmental seal (21, 22; 74) is disposed in the area of overlap.

15. Housing according to Claim 14, **characterized in that** the environmental seal comprises a plastic cord (22; 74) which is seated in a groove (24; 75) in one frame profile (1) and is pressed against the flange (21; 72) of the other frame profile (2; 52).

16. Housing according to Claim 15, **characterized in that** the plastic cord (22; 74) has a metal insert (23).

17. Housing according to Claim 15 or 16, **characterized in that** the plastic cord (22) is supported at the bottom of the groove by way of ribs (25, 26).

18. Housing according to one of Claims 1 to 17, **characterized in that** one of the frame profiles (1) takes the form of a hollow profile (3) which, on the side facing away from the interlocking profiles (27, 28), forms another area of overlap with a section of wall (7), hollow profile (3) and section of wall (7) being joined together in this area by way of fastening means to form contact surfaces (13, 14, 15, 16).

19. Housing according to Claim 18, **characterized in that** hollow profile (3) and section of wall (7) form second interlocking profiles with the formation of contact surfaces (13, 14, 15, 16).

20. Housing according to Claim 19, **characterized in that** the interlocking profile on the hollow-profile side is formed by grooves (9, 10), having contact surfaces at the mouths of the grooves, in which interlocking flanges (11, 12) formed on the wall-section side engage.

21. Housing according to one of Claims 1 to 20, **characterized in that** the frame profiles (51, 52) form another area of overlap on the side facing away from the interlocking profiles (76, 77) and there adjoin one another over at least one additional screening element (94).

22. Housing according to one of Claims 1 to 21, **characterized in that** the screening elements are partly in the form of longitudinal plate springs (88, 91, 94).

## Revendications

1. Carrosserie avec des parois (67) et au moins une ouverture dans les parois qui peut être fermée par un dispositif de fermeture, par exemple sous la forme d'une porte (71) ou d'une fenêtre, sachant que le dispositif de fermeture (71) et l'ouverture sont entourés par des profilés d'encadrement (1, 2 ; 51, 52) formant des zones de chevauchement et présentant un dispositif de protection pour réaliser entre les profilés d'encadrement (1, 2 ; 51, 52) un blindage contre les ondes et les impulsions à haute fréquence, sachant que les zones de chevauchement sur les côté tournés l'un vers l'autre présentent des profils encastrables complémentaires (27, 28 ; 76, 77) qui sont réalisés en tant que profils cannelés (29, 31 ; 78, 80) avec des surfaces obliques opposées qui s'enchâssent l'une dans l'autre, sachant qu'il y a des surfaces obliques opposées, **caractérisée en ce que** les surfaces obliques sont appliquées l'une contre l'autre en formant des surfaces de contact (33, 34, 35 ; 82, 83, 84, 85).

2. Carrosserie selon la revendication 1, **caractérisée en ce que** les profils encastrables (27, 28 ; 76, 77) sont réalisés de telle sorte qu'il se forme au moins trois paires de surfaces de contact appliquées l'une contre l'autre (33, 34, 35 ; 82, 83, 84, 85).

3. Carrosserie selon la revendication 1 ou 2, **caractérisée en ce que** les surfaces de contact (33, 34, 35 ; 82, 83, 84, 85) sont recouvertes d'étain.

4. Carrosserie selon l'une des revendications 1 à 3, **caractérisée en ce qu'**au moins l'un des profils encastrables (27, 28 ; 77) présente au moins une rainure longitudinale (38, 39) dans laquelle est chaque fois logé un élément de blindage (40, 41 ; 88, 91).

5. Carrosserie selon la revendication 4, **caractérisée en ce que** la rainure longitudinale ou au moins l'une des rainures longitudinales (38, 39) est ménagée dans une surface de contact (33, 35 ; 84).

6. Carrosserie selon la revendication 5, **caractérisée en ce qu'**un ressort hélicoïdal (40, 41) est chaque fois logé dans la (les) rainure(s) en tant qu'élément de blindage, qui, lorsque le dispositif de fermeture est fermé, est chaque fois appliqué contre la surface de contact opposée.

7. Carrosserie selon la revendication 6, **caractérisée en ce que** le ressort hélicoïdal (40, 41) est composé de fil métallique plat.

8. Carrosserie selon la revendication 6 ou 7, **caractérisée en ce que** le(s) ressort(s) hélicoïdal (hélicoïdaux) (40, 41) présente(nt) une âme.

9. Carrosserie selon l'une des revendications 5 à 8, **caractérisée en ce que** deux rainures longitudinales (38, 39) sont prévues.

10. Carrosserie selon l'une des revendications 1 à 9, **caractérisée en ce qu'**une rainure longitudinale (36, 37 ; 87) est prévue dans au moins un fond du (des) profil(s) encastrable(s) (27, 28).

11. Carrosserie selon la revendication 10, **caractérisée en ce que** des rainures longitudinales (36, 37) sont ménagées dans chaque fond de profil.

12. Carrosserie selon la revendication 10 ou 11, **caractérisée en ce qu'**un élément de blindage est chaque fois logé dans la (les) rainure(s) longitudinale(s).

13. Carrosserie selon la revendication 12, **caractérisée en ce qu'**un cordon d'étanchéité, par exemple un tissu à mailles métalliques avec une âme, est logé dans la (les) rainure(s) longitudinale(s) (36, 37).

14. Carrosserie selon l'une des revendications 1 à 13, **caractérisée en ce qu'**un joint vis-à-vis de l'extérieur (21, 22 ; 74) est disposé dans la zone de chevauchement.

15. Carrosserie selon la revendication 14, **caractérisée en ce que** le joint vis-à-vis de l'extérieur présente un boudin en matière plastique (22 ; 74) qui est logé dans une rainure (24 ; 75) dans l'un des profilés d'encadrement (1) et qui est pressé contre une aile (21 ; 72) de l'autre profilé d'encadrement (2 ; 52).

16. Carrosserie selon la revendication 15, **caractérisée en ce que** le boudin en matière plastique (22 ; 74) présente une armature métallique (23).

17. Carrosserie selon la revendication 15 ou 16, **caractérisée en ce que** le boudin en matière plastique (22) prend appui dans le fond de la rainure par le biais de nervures (25, 26).

18. Carrosserie selon l'une des revendications 1 à 17, **caractérisée en ce que** l'un des profilés d'encadrement (1) est réalisé en tant que profilé creux (3) qui forme avec un segment de paroi (7) sur le côté opposé aux profils encastrables (27, 28) une zone de chevauchement supplémentaire, sachant que le profilé creux (3) et le segment de paroi (7) sont assemblés dans cette zone par des moyens de fixation en formant des surfaces de contact (13, 14, 15, 16).

19. Carrosserie selon la revendication 18, **caractérisée en ce que** le profilé creux (3) et le segment de paroi (7) forment des seconds profils encastrables munis de surfaces de contact (13, 14, 15, 16).

20. Carrosserie selon la revendication 19, **caractérisée en ce que** le profil encastrable situé du côté du profilé creux est constitué par des rainures (9, 10) munies de surfaces de contact aux extrémités de la rainure, dans lesquelles s'encastrent des ailes encastrables (11, 12) ménagées du côté du segment de paroi.

21. Carrosserie selon l'une des revendications 1 à 20, **caractérisée en ce que** les profilés d'encadrement (51, 52) forment sur le côté opposé aux profils encastrables (76, 77) une zone de chevauchement supplémentaire et sont appliqués l'un contre l'autre à cet endroit-là par l'intermédiaire d'au moins un autre élément de blindage (94).

22. Carrosserie selon l'une des revendications 1 à 21, **caractérisée en ce que** les éléments de blindage sont en partie réalisés en tant que ressorts à lames longitudinaux (88, 91, 94).
